# FASCICULE DE BREVET EUROPEEN

(11) **EP 4 092 739 B1**
(45) Date de publication et mention de la délivrance du brevet: **11.02.2026**
(21) Numéro de dépôt: 22172226.7
(22) Date de dépôt: 09.05.2022
(51) Int. Cl.: H01L 25/16, H10F 55/15, H10H 20/01, H10H 29/01, H10H 29/39, H10H 29/80, H10H 20/825, H10H 20/831, H10H 29/14, H10H 29/851

(54) **PROCÉDÉ DE FABRICATION D'UN DISPOSITIF OPTOÉLECTRONIQUE, DISPOSITIF CORRESPONDANT ET SYSTÈME LE COMPRENANT**
VERFAHREN ZUR HERSTELLUNG EINER OPTOELEKTRONISCHEN VORRICHTUNG, ENTSPRECHENDE VORRICHTUNG UND SYSTEM MIT DIESER VORRICHTUNG
METHOD FOR MANUFACTURING AN OPTOELECTRONIC DEVICE, CORRESPONDING DEVICE AND SYSTEM COMPRISING THE SAME

(30) Priorité: 18.05.2021 FR 2105160; 28.10.2021 FR 2111479
(43) Date de publication de la demande: 23.11.2022
(73) Titulaire: Commissariat à l'Energie Atomique et aux Energies Alternatives, 75015 Paris (FR)
(72) Inventeur: TEMPLIER, François, 38054 GRENOBLE CEDEX 09 (FR); BECKER, Sébastien, 38054 GRENOBLE CEDEX 09 (FR)
(74) Mandataire: Cabinet Beaumont

(56) Documents cités:
- EP-A1- 3 667 728
- US-A1- 2017 155 020
- US-A1- 2021 134 654
- ERIC Z X LIU ET AL: "Recent progress of heterogeneous integration for semiconductor materials and microsystems", SOLID-STATE AND INTEGRATED CIRCUIT TECHNOLOGY, 2006. ICSICT '06. 8TH INTERNATIONAL CONFERENCE ON, IEEE, PI, 1 October 2006 (2006-10-01), pages 520 - 523, XP031045635, ISBN: 978-1-4244-0160-4
- LIU XIAOYAN ET AL: "High-Bandwidth InGaN Self-Powered Detector Arrays toward MIMO Visible Light Communication Based on Micro-LED Arrays", ACS PHOTONICS, 18 December 2019 (2019-12-18), pages 3186 - 3195, XP055870321, Retrieved from the Internet <URL:https://pubs.acs.org/doi/pdf/10.1021/acsphotonics.9b00799> [retrieved on 20211207], DOI: 10.1021/acsphotonics.9b00799

## Description

### Domaine technique

La présente invention concerne de façon générale le domaine des dispositifs optoélectroniques, et vise plus particulièrement un procédé de fabrication d'un dispositif optoélectronique combinant une fonction d'émission lumineuse et une fonction de capture optique.

### Technique antérieure

Diverses applications sont susceptibles de tirer profit d'un dispositif optoélectronique combinant une fonction d'émission lumineuse et une fonction de capture optique. Un tel dispositif peut par exemple être utilisé pour réaliser un écran d'affichage interactif.

Les demandes de brevet: US 2021/0134654 A1 (06-05-2021) et EP 3 667 728 A1 (17-06-2020) appartiennent à l'état de la technique dans ce domaine. Il en est de même des articles scientifiques: *"*Recent Progress of Heterogeneous Integration for Semiconductor Materials and Microsystems", Eric Z. X. Liu et al., Solid-State and Integrated Circuit Technology, 2006, ICSICT'06, pages 520-523 (01-10-2006), et *"*High-Bandwidth InGaN Self-Powered Detector Arrays toward MIMO Visible Light Communication Based on Micro-LED Arrays", Liu Xiaoyan et al., ACS photonics 2019, 6, pages 3186-3195 (18-12-2019).

### Résumé de l'invention

Un objet d'un mode de réalisation est de pallier tout ou partie des inconvénients des solutions connues pour réaliser un dispositif optoélectronique combinant une fonction d'émission lumineuse et une fonction de capture optique.

La présente invention couvre un procédé de fabrication d'un dispositif optoélectronique, comportant les étapes suivantes :
a) disposer un empilement actif de diode photosensible sur un premier substrat ;
b) reporter l'empilement actif de diode photosensible sur un circuit intégré de contrôle préalablement formé dans et sur un deuxième substrat semiconducteur, puis retirer le premier substrat ;
c) disposer un empilement actif de diode électroluminescente sur un troisième substrat ; et
d) après les étapes b) et c), reporter l'empilement actif de diode électroluminescente sur l'empilement actif de diode photosensible, puis retirer le troisième substrat.

Selon un mode de réalisation, l'empilement actif de diode photosensible comprend au moins une couche semiconductrice inorganique, par exemple en un matériau III-V, et l'empilement actif de diode électroluminescente comprend au moins une couche semiconductrice inorganique, par exemple en un matériau III-V.

Selon un mode de réalisation, l'empilement actif de diode photosensible comprend des première, deuxième et troisième couches semiconductrices, la deuxième couche étant disposée entre les première et troisième couches.

Selon un mode de réalisation, le procédé comprend une étape de dopage de type P de portions localisées de la première couche, lesdites portions définissant des régions d'anode de diodes photosensibles du dispositif.

Selon un mode de réalisation, l'étape de dopage de type P des portions localisées de la première couche est mise en oeuvre après l'étape b) et avant l'étape d).

Selon un mode de réalisation, l'étape de dopage de type P des portions localisées de la première couche est mise en oeuvre avant l'étape b).

Selon un mode de réalisation, le procédé comprend en outre une étape de formation de métallisations de connexion sur et en contact avec lesdites portions localisées de la première couche.

Selon un mode de réalisation, à l'issue de l'étape b), l'empilement actif de diode photosensible s'étend de façon continue sur toute la surface du circuit intégré de contrôle.

Selon un mode de réalisation, à l'issue de l'étape d), l'empilement actif de diode électroluminescente s'étend de façon continue sur toute la surface du circuit intégré de contrôle.

Selon un mode de réalisation, le procédé comprend en outre, après l'étape b) et avant l'étape d), une étape de formation de vias conducteurs traversant l'empilement actif de diode photosensible.

Selon un mode de réalisation, les vias conducteurs sont connectés électriquement à des plots métalliques de connexion du circuit intégré.

Selon un mode de réalisation, le procédé comprend en outre, après l'étape d), une étape de gravure localisée de l'empilement actif de diode électroluminescente de façon à former dans l'empilement actif de diode électroluminescente une pluralité de pavés définissant chacun une diode électroluminescente.

Selon un mode de réalisation, le procédé comprend la formation d'éléments de conversion de couleur au-dessus d'au moins certaines des diodes électroluminescentes.

Selon un mode de réalisation, au moins une des diodes électroluminescentes est surmontée d'un élément de conversion photoluminescent adapté à convertir la lumière émise par la diode électroluminescente vers une longueur d'onde visible et au moins une autre des diodes électroluminescentes est surmontée d'un élément de conversion photoluminescent adapté à convertir la lumière émise par la diode électroluminescente en un rayonnement lumineux dans la gamme de longueurs d'ondes de sensibilité de l'empilement actif de diode photosensible, de préférence un rayonnement infrarouge.

Selon un mode de réalisation, au moins une des diodes électroluminescentes n'est pas surmontée par un élément de conversion photoluminescent.

Selon un mode de réalisation, les éléments de conversion photoluminescents sont réalisés à base de boîtes quantiques ou de matériaux pérovskites.

Selon un mode de réalisation, le procédé comporte, après l'étape d), une étape de fixation d'un substrat de support temporaire du côté de l'empilement actif de diode électroluminescente opposé au circuit intégré, suivie d'une étape de découpe de l'ensemble comportant le circuit intégré, l'empilement actif de diode photosensible et l'empilement actif de diode électroluminescente en une pluralité de puces élémentaires.

Selon un mode de réalisation, le procédé comporte en outre une étape de transfert et de fixation des puces élémentaires sur un substrat de report du dispositif, puis une étape de retrait du substrat de support temporaire.

La présente invention couvre également un dispositif optoélectronique comportant un substrat de report et une pluralité de puces élémentaires fixées et connectées électriquement au substrat de report, chaque puce élémentaire comportant un empilement comportant, dans l'ordre à partir de la face supérieure du substrat de report, un circuit intégré de contrôle formé dans et sur un substrat semiconducteur, un étage de photodétection comportant au moins une diode photosensible, et un étage d'émission comportant au moins une diode électroluminescente.

Selon un mode de réalisation, dans chaque puce élémentaire, l'étage de photodétection est disposé entre le circuit intégré de contrôle et l'étage d'émission, et la diode photosensible a une couche semiconductrice d'anode disposée du côté de l'étage d'émission et une couche semiconductrice de cathode disposée du côté du circuit intégré de contrôle.

La présente **invention** couvre aussi un système comportant un dispositif optoélectronique réalisé par un procédé tel que défini ci-dessus, et une source lumineuse adaptée à émettre un rayonnement lumineux dans la gamme de longueurs d'ondes de sensibilité de l'empilement actif de diode photosensible, de préférence un rayonnement infrarouge.

Selon un mode de réalisation, la source lumineuse est une source déportée.

Selon un mode de réalisation, la source lumineuse est intégrée au dispositif optoélectronique et comprend au moins une diode électroluminescente formée dans l'empilement actif de diode électroluminescente.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A, 1B, 1C, 1D, 1E, 1F, 1G, 1H, 1I et 1J sont des vues en coupe illustrant des étapes successives d'un exemple d'un procédé de fabrication d'un dispositif optoélectronique selon un mode de réalisation ;
les figures 2A, 2B, 2C, 2D, 2E, 2F, et 2G sont des vues en coupe illustrant d'autres étapes successives d'un exemple d'un procédé de fabrication d'un dispositif optoélectronique selon un mode de réalisation ;
la figure 3 représente de façon schématique un exemple d'un système comprenant un dispositif optoélectronique selon un mode de réalisation ;
la figure 4 est une vue en coupe illustrant de façon schématique et partielle un autre exemple d'un dispositif optoélectronique selon un mode de réalisation ; et
la figure 5 est une vue en coupe illustrant de façon schématique et partielle une variante de réalisation du dispositif de la figure 4.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation des diodes photosensibles, des diodes électroluminescentes (LED) et des circuits intégrés de contrôle des dispositifs décrits n'a pas été détaillée, la réalisation détaillée de ces éléments étant à la portée de la personne du métier à partir des indications de la présente description. De plus, les diverses applications que peuvent avoir les dispositifs décrits n'ont pas détaillées, les modes de réalisation décrits étant compatibles avec toutes ou la plupart des applications susceptibles de tirer profit d'un dispositif combinant une fonction d'émission lumineuse et une fonction de capture optique (photodétection).

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures correspondantes.

Sauf précision contraire, les expressions "environ", "approximativement", "sensiblement", et "de l'ordre de" signifient à 10 % près, de préférence à 5 % près.

Selon un aspect d'un mode de réalisation, on prévoit, pour réaliser un dispositif optoélectronique combinant une fonction d'émission lumineuse et une fonction de photodétection, de mettre en oeuvre les étapes suivantes :
a) disposer un empilement actif de diode photosensible sur un premier substrat ;
b) reporter l'empilement actif de diode photosensible sur un circuit intégré de contrôle préalablement formé dans et sur un deuxième substrat semiconducteur, puis retirer le premier substrat ;
c) disposer un empilement actif de LED sur un troisième substrat ; et
d) après les étapes b) et c), reporter l'empilement actif de LED sur l'empilement actif de diode photosensible, puis retirer le troisième substrat.

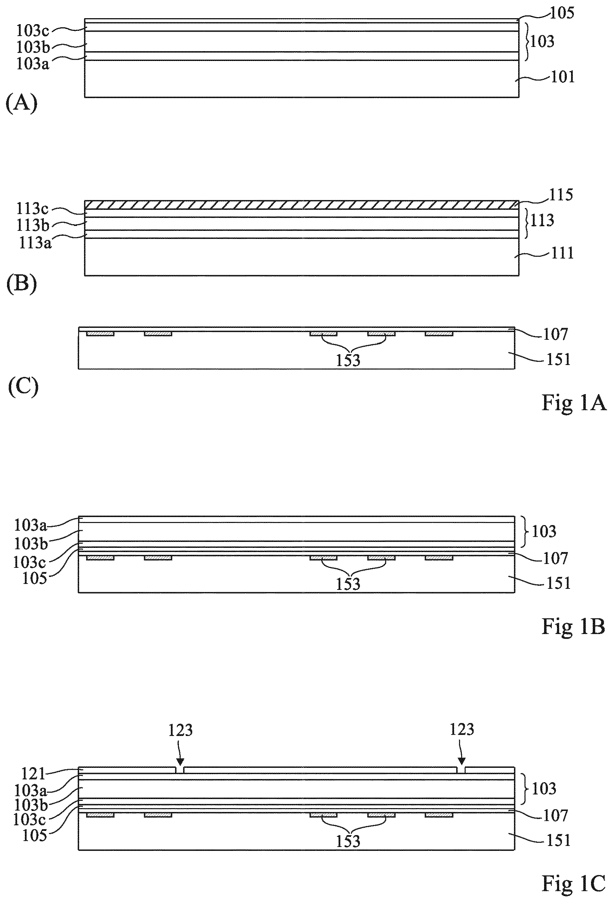

Les figures 1A à 1J sont des vues en coupe illustrant des étapes successives d'un exemple, non limitatif, de mise en oeuvre d'un tel procédé. Diverses variantes sont à la portée de la personne du métier à partir des indications de la présente description.

La figure 1A illustre schématiquement, en partie supérieure (A), la structure obtenue à l'issue d'étapes de formation d'un empilement actif de diode photosensible 103 sur la face supérieure d'un substrat 101.

L'empilement 103 est de préférence un empilement de couches semiconductrices inorganiques. L'empilement 103 comprend par exemple une ou plusieurs couches en un matériau semiconducteur de type III-V. L'empilement 103 est par exemple un empilement actif de photodiode sensible dans l'infrarouge ou le proche infrarouge. A titre de variante, l'empilement 103 est un empilement actif de photodiode sensible dans le visible. A titre d'exemple, l'empilement 103 comprend, dans l'ordre à partir de la face supérieure du substrat 101, une couche 103a en phosphure d'indium (InP) non intentionnellement dopé, une couche d'absorption 103b en arséniure d'indium-gallium (InGaAs), par exemple intrinsèque ou faiblement dopé de type N (par exemple de l'ordre de 10¹⁵ atomes/cm³), et une couche 103c en phosphure d'indium (InP) dopé de type N. A titre d'exemple, le niveau de dopage de type N de la couche 103c est compris entre 10¹⁶ et 10¹⁸ atomes/cm³. Dans cet exemple, la couche 103b est en contact, par sa face inférieure, avec la face supérieure de la couche 103a, et la couche 103c est en contact, par sa face inférieure, avec la face supérieure de la couche 103b.

Le substrat 101 est par exemple en phosphure d'indium. Les couches 103a, 103b et 103c peuvent être formées successivement par épitaxie sur la face supérieure du substrat 101. Le substrat 101 est alors un substrat de croissance. Une couche tampon, non représentée, par exemple en phosphure d'indium, peut éventuellement faire interface entre le substrat 101 et la couche 103a. La couche tampon est par exemple en contact, par sa face inférieure, avec la face supérieure du substrat 101, et, par sa face supérieure, avec la face inférieure de la couche 103a. La couche tampon peut également être formée par épitaxie à partir de la face supérieure du substrat 101, avant la formation des couches 103a, 103b et 103c.

A titre de variante, plutôt que de former l'empilement actif de diode photosensible 103 par épitaxie sur la face supérieure du substrat 101, l'empilement actif peut être formé dans l'ordre inverse sur un substrat de croissance, non représenté, puis reporté et fixé sur le substrat 101. Dans ce cas, les couches 103c, 103b et 103a sont successivement formées par épitaxie sur une face du substrat de croissance. Une couche tampon, par exemple en phosphure d'indium, peut éventuellement faire interface entre le substrat de croissance et la couche 103c. L'empilement 103 est ensuite fixé sur la face supérieure du substrat 101, par exemple par collage direct ou collage moléculaire de la face inférieure de la couche 103a sur la face supérieure du substrat 101. A titre de variante, d'autres méthodes de collage peuvent être utilisées. Le substrat de croissance, et, le cas échéant, la couche tampon faisant interface entre le substrat de croissance et la couche 103c, sont ensuite être retirés de façon à libérer l'accès à la face supérieure de la couche 103c. Dans cette variante, le substrat 101 est un substrat de support, par exemple en silicium, ou en tout autre matériau adapté à servir de support de réception de l'empilement actif 103.

La figure 1A illustre de plus, en partie supérieure (A), une étape de dépôt d'une couche diélectrique 105, par exemple en oxyde de silicium ou en nitrure de silicium, sur et en contact avec la face supérieure de la couche supérieure 103c de l'empilement actif de diode photosensible 103. Dans cet exemple, la couche diélectrique 105 s'étend de façon continue et avec une épaisseur sensiblement uniforme sur toute la surface supérieure de la couche 103c.

La figure 1A illustre en outre schématiquement, en partie intermédiaire (B), la structure obtenue à l'issue d'étapes de formation d'un empilement actif de LED 113 sur la face supérieure d'un substrat 111.

L'empilement 113 est de préférence un empilement de couches semiconductrices inorganiques. L'empilement 113 comprend par exemple une ou plusieurs couches en un matériau semiconducteur de type III-V. L'empilement 113 est par exemple un empilement actif de LED adapté à émettre de la lumière visible, par exemple majoritairement de la lumière bleue. A titre d'exemple, l'empilement 113 est un empilement actif de LED au nitrure de gallium (GaN). A titre d'exemple, l'empilement 113 comprend, dans l'ordre à partir de la face supérieure du substrat 111, une couche semiconductrice 113a dopée de type N, formant une couche de cathode de l'empilement de LED, une couche active 113b, et une couche semiconductrice 113c dopée de type P, formant une couche d'anode de l'empilement de LED. La couche 113a est par exemple en nitrure de gallium. La couche active 113b est par exemple un empilement à puits quantiques multiples (non détaillé sur la figure), constitué d'une alternance de couches semiconductrices d'un premier matériau, par exemple un matériau de type III-V, et de couches semiconductrices d'un deuxième matériau, par exemple un matériau de type III-V, chaque couche du premier matériau étant prise en sandwich entre deux couches du deuxième matériau et définissant un puits quantique. La couche 113c est par exemple en nitrure de gallium. La couche active 113b est par exemple en contact, par sa face inférieure, avec la face supérieure de la couche 113a. La couche 113c est par exemple en contact, par sa face inférieure, avec la face supérieure de la couche active 113b.

Le substrat 111 est par exemple en silicium, en saphire, ou en nitrure de gallium. A titre d'exemple, les couches 113a, 113b et 113c sont successivement formées par épitaxie sur la face supérieure du substrat 111. Une couche tampon, non représentée, peut éventuellement faire interface entre la face supérieure du substrat 111 et la face inférieure de la couche 113a.

A ce stade, chacune des couches de l'empilement actif de diode photosensible 103 s'étend par exemple de façon continue et avec une épaisseur sensiblement uniforme sur toute la surface supérieure du substrat 101. De plus, chacune des couches de l'empilement actif de LED 113 s'étend par exemple de façon continue et avec une épaisseur sensiblement uniforme sur toute la surface supérieure du substrat 111. Les substrats 101 et 111 ont par exemple sensiblement les mêmes dimensions latérales.

La figure 1A illustre en outre, en partie intermédiaire (B), une étape de dépôt d'une couche conductrice 115 sur et en contact avec la face supérieure de la couche semiconductrice 113c. La couche 115 forme un contact ohmique avec le matériau semiconducteur de la couche 113c. La couche 115 est par exemple en aluminium, en nickel, ou encore en un oxyde conducteur transparent, par exemple en oxyde d'indium-étain (ITO). A ce stade, la couche métallique 115 s'étend de façon continue et avec une épaisseur sensiblement uniforme sur toute la surface supérieure de la couche 113c. La couche 115 peut en outre avoir une fonction de réflecteur optique. A titre d'exemple, la couche 115 peut comprendre deux couches superposées assurant respectivement la fonction de contact ohmique avec le matériau semiconducteur de la couche 113c et la fonction de réflecteur optique.

Lafigure 1A illustre de plus schématiquement, en partie inférieure (C), un circuit intégré de contrôle 151 préalablement formé dans et sur un substrat semiconducteur, par exemple en silicium. Le circuit intégré de contrôle 151 comprend des circuits de contrôle et de lecture des LED et des diodes photosensibles du dispositif. A titre d'exemple, le circuit intégré 151 comprend un ensemble de cellules élémentaires de contrôle et de lecture, permettant de contrôler et de lire individuellement chaque LED et chaque diode photosensible du dispositif. Le circuit intégré 151 est par exemple un circuit CMOS (de l'anglais "Complementary Metal Oxide Semiconductor" - métal oxyde semiconducteur complémentaire). Dans cet exemple, le circuit 151 comprend une pluralité de plots métalliques de connexion 153 disposés du côté de sa face supérieure.

Lafigure 1A illustre de plus, en partie supérieure (C), une étape de dépôt d'une couche diélectrique 107, par exemple en oxyde de silicium ou en nitrure de silicium, par exemple en le même matériau que la couche 105, sur et en contact avec la face supérieure du circuit intégré de contrôle 151. Dans cet exemple, la couche diélectrique 107 s'étend de façon continue et avec une épaisseur sensiblement uniforme sur toute la surface supérieure du circuit intégré de contrôle 151.

La figure 1B illustre la structure obtenue à l'issue d'une étape de report et de fixation de l'empilement actif de diode photosensible 103 sur le circuit intégré de contrôle 151, puis de retrait du substrat 101. Lors de cette étape, l'empilement actif de diode photosensible 103 est reporté sur le circuit intégré 151, en utilisant le substrat 101 comme poignée de support. Sur la figure 1B, la structure comportant le substrat 101 et l'empilement 103 est retournée par rapport à l'orientation de lafigure 1A. L'empilement 103 est ensuite fixé sur le circuit intégré 151. Dans cet exemple, l'empilement 103 est fixé par collage direct ou collage moléculaire de la face inférieure (dans l'orientation de la figure 1B, correspondant à la face supérieure dans l'orientation de lafigure 1A) de la couche 105, sur la face supérieure (dans l'orientation de la figure 1B, correspondant à la face supérieure dans l'orientation de la figure 1A) de la couche 107. A titre de variante, d'autres méthodes de fixation peuvent être utilisées. Le substrat 101 est ensuite retiré, par exemple par meulage et/ou gravure chimique, de façon à libérer l'accès à la face supérieure de la couche 103a. A ce stade, chacune des couches de l'empilement actif de diode photosensible 103 s'étend par exemple de façon continue et avec une épaisseur sensiblement uniforme, sur toute la surface du circuit intégré de contrôle 151. On notera que, dans cet exemple, l'empilement actif 103 est non structuré et n'a subi aucune étape de traitement localisé avant l'étape de report. Ainsi, l'étape de report ne requiert pas d'alignement précis.

La figure 1C illustre une étape de dépôt d'une couche diélectrique 121, par exemple en nitrure de silicium ou en oxyde de silicium, sur la face supérieure de la couche 103a, par exemple en contact avec la face supérieure de la couche 103a. La couche 121 est par exemple déposée par un procédé de dépôt chimique en phase vapeur assisté par plasma (PECVD). La couche 121 est par exemple déposée de façon continue et avec une épaisseur uniforme sur toute la surface supérieure de la couche 103a. La figure 1C illustre en outre une étape de formation d'ouvertures traversantes localisées 123 dans la couche diélectrique 121. Les ouvertures 123 sont par exemple formées par photolithographie et gravure. Les ouvertures sont disposées en vis-à-vis de futures zones de reprise de contact de type P correspondant à des régions d'anode des diodes photosensibles du dispositif.

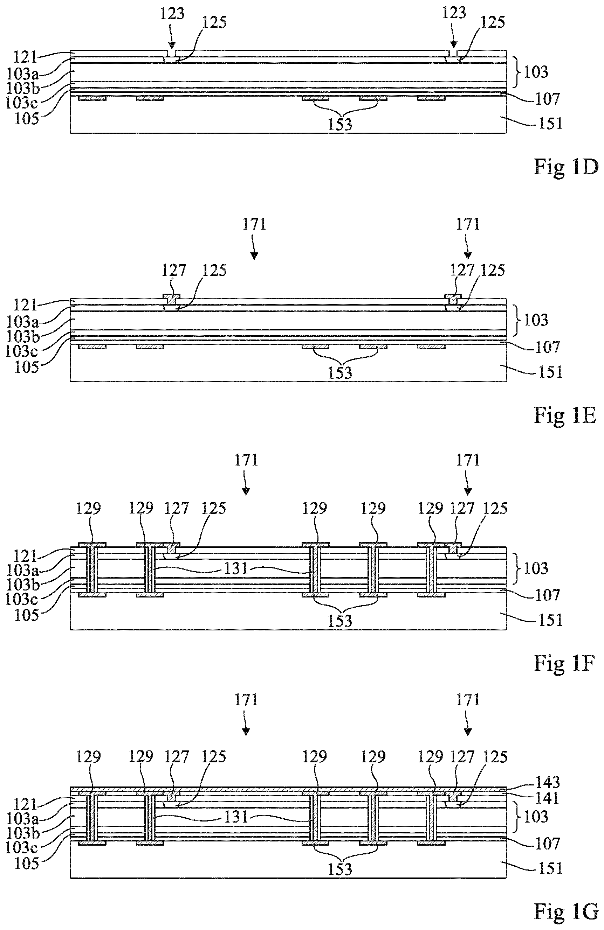

La figure 1D illustre une étape de dopage de type P de régions localisées 125 de la couche 103a, situées en vis-à-vis des ouvertures 123. Le dopage des régions 125 peut être réalisé par diffusion ou implantation d'éléments dopants de type P, par exemple du zinc (Zn) ou du béryllium (Be), en vis-à-vis des ouvertures 123. Un recuit d'activation des éléments dopants peut ensuite être mis en oeuvre. A titre d'exemple, le recuit d'activation peut être un recuit laser superficiel, ce qui permet de ne pas endommager les composants de circuit intégré 151, ni altérer la qualité du collage entre le circuit intégré 151 et l'empilement actif de diode photosensible 103. Les régions dopées de type P 125 forment des régions d'anode des diodes photosensibles du dispositif. Dans cet exemple, les régions 125 s'étendent sur toute l'épaisseur de la couche 103a, et viennent en contact, par leur face inférieure, avec la face supérieure de la couche d'absorption 103b.

La figure 1E illustre une étape de formation de métallisations de reprise de contact 127 dans les ouvertures 123. Chaque métallisation 127 vient contacter individuellement la région 125 sous-jacente, à travers l'ouverture 123 correspondante. A titre d'exemple, une couche métallique est d'abord déposée de façon continue sur toute la surface supérieure de la structure, c'est-à-dire sur et en contact avec la face supérieure de la couche diélectrique 121 et dans les ouvertures 123, puis retirée par photolithographie et gravure de façon à conserver uniquement les métallisations 127. Dans cet exemple, chaque métallisation 127 constitue une électrode d'anode d'une diode photosensible 171 du dispositif.

La figure 1F illustre la structure obtenue à l'issue d'étapes de formation de vias conducteurs 129 isolés latéralement, traversant l'empilement actif de diode photosensible 103. Plus particulièrement, dans cet exemple, les vias conducteurs 129 traversent la couche 121, les couches 103a, 103b et 103c de l'empilement 103, les couches isolantes 105 et 107, et débouchent chacun sur et en contact avec la face supérieure d'un plot métallique 153 du circuit intégré de contrôle. La réalisation des vias 129 comprend une étape de gravure, à partir de la face supérieure de la couche isolante 121, d'ouverture traversantes dans l'empilement formé par les couches 107, 105, 103c, 103b, 103a et 121. Les ouvertures sont par exemple formées par gravure plasma, par exemple de type ICP (de l'anglais Inductively Coupled Plasma - plasma à couplage inductif). Une étape de passivation des flancs des ouvertures, est ensuite mise en oeuvre. Lors de cette étape, une couche 131 d'un matériau isolant, par exemple de l'oxyde de silicium, est déposée sur les parois latérales et au fond des ouvertures. Une étape de gravure anisotrope verticale peut ensuite être mise en oeuvre pour retirer la couche isolante au fond des ouvertures, sans la retirer sur les parois latérales. Les ouvertures sont ensuite remplies de métal pour former les vias conducteurs 129.

Avant ou après la formation des vias conducteurs 129, un ou plusieurs vias conducteurs (non visibles sur les figures) de reprise de contact sur la couche de cathode 103c de l'empilement de diode photosensible peuvent être formés. Ces vias de reprise de contact de cathode sont similaires aux vias 129 représentés sur la figure 1F, à savoir qu'ils traversent la couche 121, les couches 103a, 103b et 103c de l'empilement 103, les couches isolantes 105 et 107, et débouchent sur et en contact avec la face supérieure d'un plot métallique 153. Les vias de reprise de contact de cathode diffèrent des vias 129 en ce qu'ils sont en contact, latéralement, avec les flancs de la couche semiconductrice de cathode 103c de l'empilement de diode photosensible. Les vias de reprise de contact de cathode sont en revanche isolés latéralement de la couche semiconductrice d'anode 103a par une couche d'isolation latérale. Pour réaliser la couche d'isolation latérale revêtant les flancs de la couche semiconductrice d'anode 103a et ne revêtant pas les flancs de la couche semiconductrice de cathode 103c, une possibilité est de déposer le matériau isolant de passivation par pulvérisation, avec un angle d'incidence, de façon que le matériau isolant se dépose uniquement sur une partie supérieure des parois de l'ouverture du via. La profondeur du dépôt peut être ajustée en jouant sur l'angle d'inclinaison appliqué. A titre de variante, les vias de reprise de contact de cathode peuvent être réalisés en deux étapes de gravure successives. Lors d'une première étape de gravure, une première ouverture traversant la couche semiconductrice d'anode 103a et tout ou partie de la couche d'absorption 103b est formée. Une couche isolante de passivation est ensuite déposée sur les parois latérales de la première ouverture. Lors d'une seconde étape de gravure, une deuxième ouverture traversant la couche semiconductrice de cathode 103c est formée, la deuxième ouverture ayant des dimensions latérales inférieures à celles de la première ouverture. Les première et deuxième ouvertures sont ensuite remplies de métal.

La figure 1G illustre la structure obtenue à l'issue d'une étape de dépôt d'une couche métallique 143 sur la face supérieure de la structure de la figure 1F. Dans cet exemple, la couche métallique 143 s'étend de façon continue et avec une épaisseur sensiblement uniforme sur toute la surface supérieure de la structure de la figure 1F. Dans l'exemple représenté, préalablement au dépôt de la couche métallique 143, une étape de planarisation de la face supérieure de la structure est mise en oeuvre, par exemple par un procédé de type damascène. Pour cela, une couche isolante 141, par exemple en oxyde de silicium, est déposée sur toute la face supérieure de la structure de la figure 1F, sur une épaisseur supérieure à l'épaisseur des portions des métallisations 127 et 129 en saillie de la face supérieure de la couche isolante 121. La couche isolante 141 est ensuite planarisée à partir de sa face supérieure, par exemple par polissage mécano-chimique, jusqu'à libérer l'accès à la face supérieure des métallisations 127 et 129. On obtient ainsi une surface supérieure plane présentant une alternance de régions isolantes et métalliques. La couche métallique 143 est ensuite déposée sur et en contact avec cette surface planarisée. La couche métallique 143 est par exemple en le même métal que la couche métallique 115 déposée sur la face supérieure de l'empilement de LED 113 figure 1A).

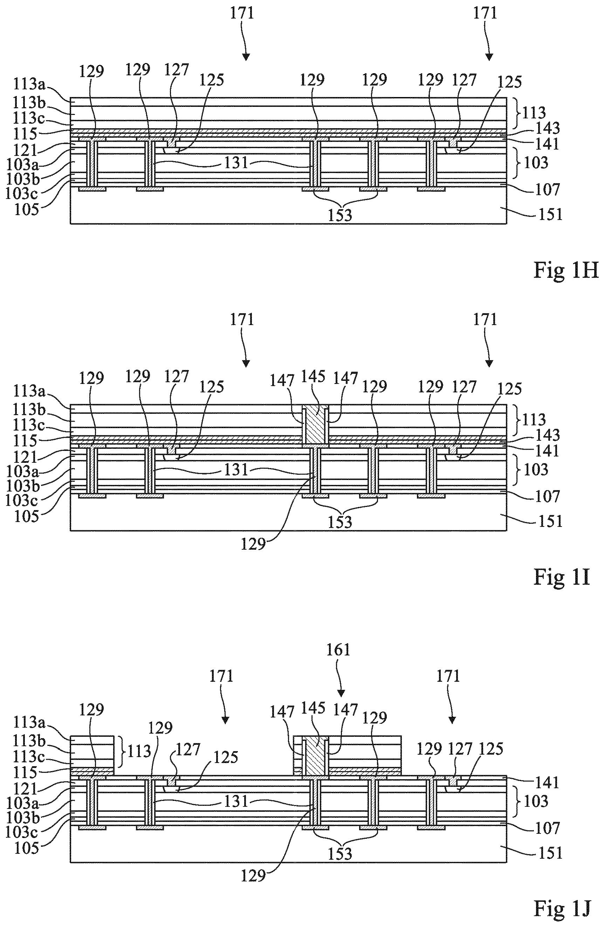

La figure 1H illustre la structure obtenue à l'issue d'une étape de report et de fixation de l'empilement actif de LED 113 sur la face supérieure de la structure de la figure 1G, puis de retrait du substrat 111. Lors de cette étape, l'empilement actif de LED 113 est reporté sur la face supérieure de la structure de la figure 1G, en utilisant le substrat 111 comme poignée de support. Sur la figure 1H, la structure comportant le substrat 111, l'empilement 113 et la couche 115 est retournée par rapport à l'orientation de la figure 1A. L'empilement 113 est ensuite fixé sur la structure de la figure 1G. A titre d'exemple, l'empilement 113 est fixé par collage direct ou collage moléculaire de la face inférieure (dans l'orientation de la figure 1H, correspondant à la face supérieure dans l'orientation de la figure 1A) de la couche 115, sur la face supérieure (dans l'orientation de la figure 1H, correspondant à la face supérieure dans l'orientation de la figure 1G) de la couche métallique supérieure 143 de la structure de la figure 1G. De préférence, le collage est un collage de type SAB (de l'anglais "Surface Activated Bonding" - collage à surfaces activées), c'est-à-dire un collage direct dans lequel les surfaces mises en contact sont préalablement activées par bombardement atomique. Le collage SAB présente l'avantage de pouvoir être mis en oeuvre à basse température, par exemple à température ambiante. Le substrat 111 est ensuite retiré, par exemple par meulage et/ou gravure chimique, ou par un procédé de décollage par laser, de façon à libérer l'accès à la face supérieure de la couche 113a. A ce stade, chacune des couches de l'empilement actif de LED 113 s'étend par exemple de façon continue et avec une épaisseur sensiblement uniforme, sur toute la surface de l'empilement actif de l'assemblage. On notera que dans cet exemple, l'empilement actif de LED 113 est non structuré et n'a subi aucune étape de traitement localisé avant l'étape de report. Ainsi, l'étape de report ne requiert pas d'alignement précis.

La figure 1I illustre la structure obtenue à l'issue d'une étape de formation de métallisations de contact de cathode 145 des LED du dispositif dans des ouvertures traversant l'empilement actif de LED 113 et les couches métalliques 115 et 143. Chaque métallisation de contact de cathode 145 s'étend verticalement depuis la face supérieure de l'empilement jusqu'à la face supérieure d'un via conducteur 129 du dispositif. Ainsi, chaque métallisation de contact de cathode 145 est connectée électriquement, par l'intermédiaire du via conducteur 129 sous-jacent, à un plot métallique de connexion 153 dédié du circuit intégré de contrôle 151.

Une étape de gravure localisée des couches 113a, 113b, 113c, 115 et 143 est d'abord mise en oeuvre pour former les ouvertures destinées à recevoir les métallisations 145. Une étape de passivation des flancs des ouvertures est ensuite mise en oeuvre. Lors de cette étape, une couche 147 d'un matériau isolant, par exemple de l'oxyde de silicium, est déposée sur les parois latérales et au fond des ouvertures. Une étape de gravure anisotrope verticale peut ensuite être mise en oeuvre pour retirer la couche isolante 147 au fond des ouvertures. La couche isolante 147 peut en outre être retirée, à l'intérieur des ouvertures, sur les flancs d'une partie supérieure de la couche de cathode 113a de l'empilement de LED 113. La couche isolante 147 est en revanche conservée, à l'intérieur des ouvertures, sur les flancs des couches 113b, 113c, 115 et 143. Les ouvertures sont ensuite remplies de métal pour former les métallisations 145. Ainsi, chaque métallisation 145 est en contact, avec la couche de type N 113a de l'empilement actif de LED au niveau des parois latérales de l'ouverture. Chaque métallisation 145 est en revanche isolée latéralement des couches 113b, 113c, 115 et 143 par la couche isolante 147.

La figure 1J illustre la structure obtenue à l'issue d'une étape de gravure localisée de l'empilement formé par les couches métalliques 143 et 115 et l'empilement actif de LED 113. Lors de cette étape seuls sont conservés des pavés 161 de l'empilement actif de LED 113, correspondant respectivement aux différentes LED 161 du dispositif. Dans cet exemple, chaque pavé de LED 161 comprend une métallisation de contact de cathode 145. La portion de l'empilement des couches métalliques 115 et 143 située sous chaque LED 161 forme une électrode d'anode de la LED et est connectée électriquement à un plot 153 dédié du circuit intégré 151 par l'intermédiaire d'un via 129.

En dehors des pavés de LED 161, l'empilement 113 et les couches métalliques 115 et 143 sont entièrement retirés, de façon à exposer la face supérieure de la couche diélectrique 141 et des métallisations 129 et 127 sous-jacentes. En particulier, dans cet exemple, l'empilement 113 et les couches 115 et 143 sont retirées en vis-à-vis des diodes photosensibles 171 du dispositif.

Une étape ultérieure de passivation des flancs des LED 161, non détaillée, peut éventuellement être prévue.

On notera que dans l'exemple représenté, les électrodes d'anode 127 des diodes photosensibles 171, et les électrodes d'anode 115, 143 et les électrodes de cathode 145 des LED 161 sont toutes connectées individuellement à des plots de connexion 153 du circuit intégré 151. La ou les électrodes de cathode des diodes photosensibles 171 peuvent être communes à toutes les diodes photosensibles 171 du dispositif, et connectées au circuit intégré 151 en périphérie du dispositif, par l'intermédiaire de vias de reprise de contact de cathode du type décrit ci-dessus.

A titre de variante, les électrodes de cathode des LED 161 peuvent être communes à toutes les LED 161 du dispositif, et connectées au circuit intégré 151 en périphérie du dispositif, de façon à limiter le nombre de vias conducteurs 129 et de plots 153. Dans une autre variante, non représentée, les électrodes de cathode des LED 161 et des diodes photosensibles 171 peuvent être communes.

En fonction de l'application envisagée, des éléments de conversion lumineuse, non représentés, peuvent éventuellement être disposés en vis-à-vis de LED 161, du côté de leurs faces supérieures, pour obtenir, sur un même dispositif, des pixels d'émission adaptés à émettre dans des gammes de longueurs d'ondes différentes, par exemple des pixels rouges, des pixels verts et des pixels bleus. Par ailleurs, des éléments de filtrage, non représentés, peuvent éventuellement être disposés en vis-à-vis de diodes photosensibles 171, du côté de leurs faces supérieures, pour obtenir, sur un même dispositif, des pixels de détection adaptés à détecter des rayonnements dans des gammes de longueurs d'ondes différentes.

Le procédé décrit en relation avec les figures 1A à 1J peut être utilisé pour réaliser des micro-écrans monolithiques, combinant une fonction d'affichage d'images et une fonction de capture optique, par exemple pour réaliser un écran interactif adapté à mettre en oeuvre des fonctions de reconnaissance de visage ou de formes, de détection de mouvement, d'identification, etc. Un avantage du procédé décrit est qu'il permet de réaliser des pixels d'affichage et des pixels de capture de petites dimensions latérales, et ainsi obtenir des résolutions d'affichage et des résolutions de capture élevées. On notera que dans l'exemple décrit ci-dessus, chaque pixel du dispositif comprend une diode photosensible 171 et une LED 161. A titre de variante, la résolution du dispositif d'affichage et la résolution du capteur optique peuvent être différentes. Par exemple, le nombre de diodes photosensibles 171 du dispositif peut être inférieure au nombre de LED 161.

A titre de variante, le procédé décrit en relation avec les figures 1A à 1Jpeut être utilisé pour réaliser des dispositifs d'affichage interactifs de plus grandes dimensions, par exemple un écran de télévision, d'ordinateur, de smartphone, de tablette numérique, etc. Un tel dispositif peut comporter une pluralité de puces électroniques élémentaires disposées, par exemple selon un agencement matriciel, sur un même substrat de report. Les puces élémentaires sont montées solidaires du substrat de report et connectées à des éléments de connexion électrique du substrat de report pour leur commande. Chaque puce comporte une ou plusieurs LED 161, une ou plusieurs diodes photosensibles 171, et un circuit 151 de commande de ladite une ou plusieurs LED et de ladite une ou plusieurs diodes photosensibles. Chaque puce correspond par exemple à un pixel du dispositif. A titre d'exemple, chaque puce comprend trois LED 161 commandables individuellement, définissant respectivement trois sous-pixels adaptés à émettre respectivement de la lumière rouge, de la lumière verte et de la lumière bleue, et une diode photosensible 171 adaptée à détecter un rayonnement infrarouge ou proche infrarouge.

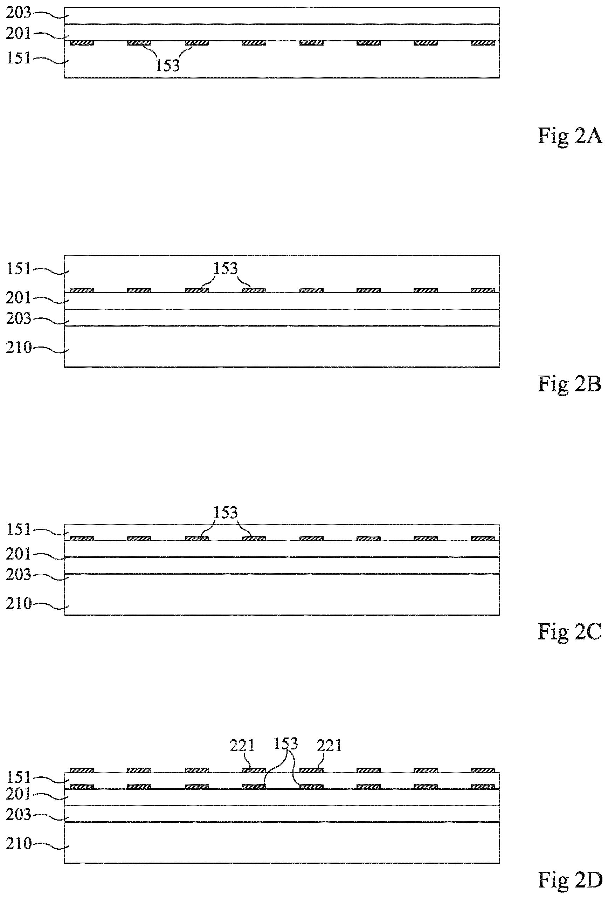

Les figures 2A à 2G sont des vues en coupe illustrant des étapes successives d'un exemple d'un procédé de fabrication d'un tel dispositif.

La figure 2A illustre de façon très schématique une structure de départ qui correspond à une structure du type obtenue par le procédé des figures 1A à 1J, comprenant un étage de circuit intégré de contrôle 151, surmonté d'un étage de photodétection 201, lui-même surmonté d'un étage d'émission 203. L'étage de photodétection 201 comprend une pluralité de diodes photosensibles 171 (non détaillées sur les figures 2A à 2G) commandables individuellement par le circuit intégré 151. L'étage d'émission comprend une pluralité de LED 161 (non détaillées sur les figures 2A à 2G) commandables individuellement par le circuit intégré 151. Sur la figure 2A, seuls les plots de connexion électrique 153 du circuit intégré 151, disposés du côté de la face supérieure du circuit intégré 151, ont été détaillés.

La figure 2B illustre une étape de collage de la structure de la figure 2A sur un substrat de support temporaire 210, par exemple en silicium. La structure de la figure 2A est fixée au substrat de support 210 par sa face opposée au circuit intégré de contrôle 151, c'est-à-dire par sa face inférieure dans l'orientation de la figure 2B, correspondant à sa face supérieure dans l'orientation de la figure 2A.

La figure 2C illustre une étape optionnelle d'amincissement du substrat semiconducteur du circuit intégré 151, par sa face opposée aux étages 201 et 203. A titre d'exemple, le circuit intégré 151 est initialement formé dans et sur un substrat de type SOI (de l'anglais "Semiconductor On Insulator" - semiconducteur sur isolant). Le substrat SOI comprend par exemple un support en silicium, revêtu d'une couche isolante, elle-même revêtue d'une couche de silicium monocristallin (non détaillés sur les figures). Les composants, notamment des transistors, du circuit intégré 151, peuvent être formés dans et sur la couche de silicium monocristallin du substrat SOI. L'étape d'amincissement de la figure 2C peut consister à retirer le substrat de support du substrat SOI, de façon à ne conserver que la couche de silicium monocristallin et la couche isolante du substrat SOI.

A titre de variante, le circuit intégré 151 est formé dans et sur un substrat massif de silicium, l'étape d'amincissement pouvant alors consister à réduire l'épaisseur du substrat, par exemple par meulage, à partir de sa face supérieure (dans l'orientation de la figure 2C). Une couche isolante de passivation (non détaillée sur la figure) peut ensuite être déposée sur la face supérieure du substrat aminci.

La figure 2D illustre une étape de formation, du côté de la face supérieure du circuit intégré 151, de plots métalliques de connexion 221, reliés aux plots de connexion 153 et/ou à des bornes de connexion de composants électroniques, par exemple des transistors MOS, du circuit intégré 151, par l'intermédiaire de vias conducteurs non détaillés sur la figure, traversant le substrat semiconducteur du circuit intégré 151.

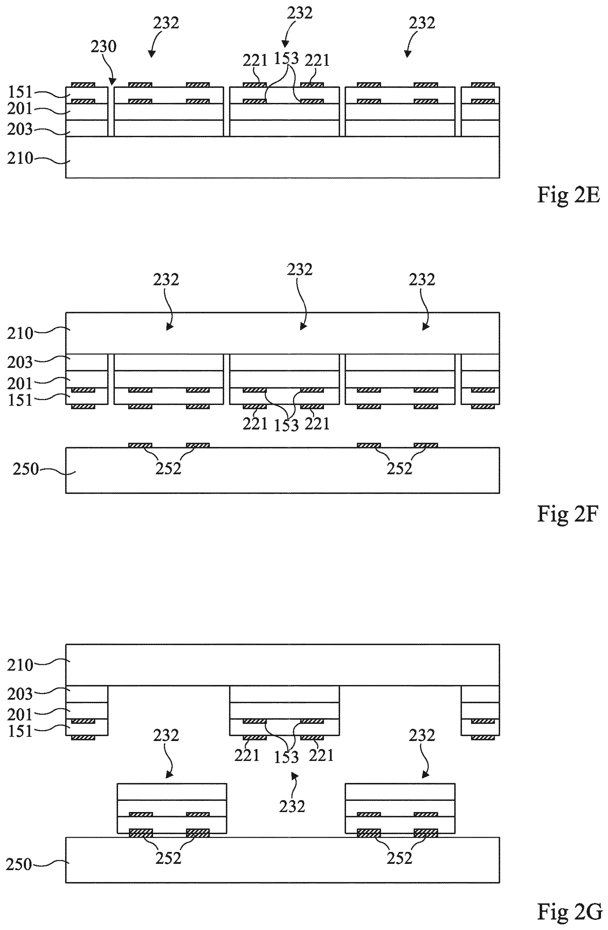

La figure 2E illustre une étape de formation, à partir de la face supérieure du circuit intégré 151, de tranchées 230 traversant verticalement le circuit intégré 151, l'étage de détection 201 et l'étage d'émission 203, et débouchant sur la face supérieure du substrat de support temporaire 210. Les tranchées 230 délimitent latéralement une pluralité de puces semiconductrices 232 correspondant aux puces élémentaires de pixel du dispositif d'affichage. Les tranchées 230 peuvent être formées par gravure plasma, par sciage, ou par toute autre méthode de découpe adaptée.

Les figures 2F et 2G illustrent une étape de fixation de puces élémentaires 232 sur la face supérieure d'un même substrat de report 250 du dispositif d'affichage. Le substrat de report 250 comprend, du côté de sa face supérieure, une pluralité de plots métalliques de connexion 252, destinés à être fixés et connectés électriquement et mécaniquement à des plots de connexion métalliques correspondants 221 des puces élémentaires 232.

La structure de la figure 2E est retournée (figure 2F) de façon à placer les plots de connexion métalliques 221 de puces élémentaires 232 en vis-à-vis de plots de connexion métalliques 252 correspondants du substrat de report 250. Les plots 221 et 252 en vis-à-vis sont ensuite fixés et connectés électriquement, par exemple par collage direct, par soudure, au moyen de microtubes, ou par toute autre méthode adaptée.

Une fois fixées au substrat de report 250, les puces élémentaires 232 sont détachées du substrat de support temporaire 210, et ce dernier est retiré (figure 2G). A titre d'exemple, le détachage des puces est réalisé par décollement mécanique ou par décollement au moyen d'un faisceau laser.

Dans l'exemple représenté, le pas (distance centre à centre en vue de face) des puces élémentaires 232 sur le substrat de report 250 est un multiple du pas des puces élémentaires 232 sur le substrat de support temporaire 210. Ainsi, seule une partie des puces élémentaires 232 (une sur deux dans l'exemple représenté) sont transférées simultanément du substrat de support temporaire 210 sur le substrat de report 250. Les autres puces 232 restent attachées au substrat de support temporaire 210 et peuvent être reportées ultérieurement sur une autre partie du substrat de report 250 ou sur un autre substrat de report 250.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation décrits ne se limitent pas aux exemples de matériaux et/ou de dimensions mentionnés dans la présente description.

En outre, dans l'exemple décrit en relation avec les figures 1A à 1J, les régions d'anode 125 et les métallisations d'anode 127 des diodes photosensibles 171 sont réalisées après le report de l'empilement actif de diode photosensible 103 sur le circuit intégré 151. A titre de variante, non détaillée sur les figures, les régions d'anode 125 et les métallisations d'anode 127 des diodes photosensibles 171 peuvent être réalisées avant le report de l'empilement actif de diode photosensible 103 sur l'empilement actif de LED 113. Dans ce cas, l'ordre des couches de l'empilement 103 est inversé par rapport à l'exemple de la figure 1A. Le collage de l'empilement actif de diode photosensible 103 sur le circuit intégré 151 est alors un collage hybride nécessitant un alignement des métallisations d'anode 127 des diodes photosensibles par rapport aux plots de connexion métalliques 153 du circuit intégré 151. Toutefois, un avantage est que le recuit d'activation des dopants des régions 125 peut alors être réalisé avant le report de l'empilement 103 sur le circuit intégré 151, ce qui évite toute dégradation du circuit intégré 151 ou du collage entre l'empilement 103 et le circuit intégré 151 lors du recuit.

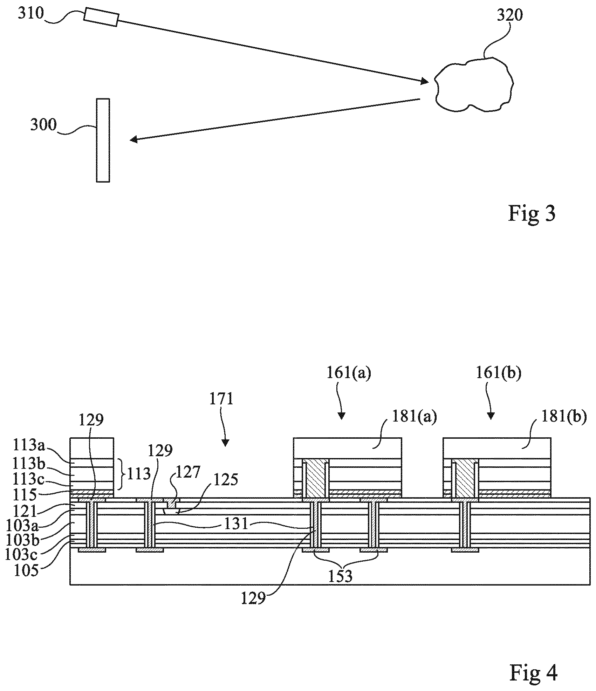

La figure 3 représente de façon schématique un exemple d'un système comprenant un dispositif optoélectronique 300 selon un mode de réalisation.

Le dispositif 300 peut être un dispositif de type micro-écran monolithique, par exemple réalisé par un procédé du type décrit en relation avec lesfigures 1A à 1J.

A titre de variante, le dispositif 300 peut être un dispositif de plus grandes dimensions, par exemple réalisé par un procédé du type décrit en relation avec les figures 2A à 2G.

Le dispositif 300 combine une fonction d'affichage d'images et une fonction de capture optique, par exemple pour réaliser un écran interactif adapté à mettre en oeuvre des fonctions de reconnaissance de visage ou de formes, de détection de mouvement, d'identification, etc.

Le système de la figure 3 comprend en outre une source lumineuse 310. La source 310 est adaptée à émettre un rayonnement lumineux dans la plage de sensibilité des diodes photosensibles 171 (non détaillées sur la figure 3) du dispositif 300. A titre d'exemple, la source 310 est une source infrarouge, par exemple une source laser.

En fonctionnement, la source 310 éclaire une scène 320 dont on souhaite acquérir une image. La lumière émise par la source 310 est réfléchie par la scène 320 et renvoyée vers le dispositif 300. Les diodes photosensibles 171 du dispositif 300 permettent alors d'acquérir une image de la scène 320 et/ou de mesurer des informations de profondeur relatives à la scène 320.

Dans l'exemple de la figure 3, la source lumineuse 310 est une source déportée, c'est-à-dire qu'elle est distincte du dispositif 300. La commande de la source lumineuse 310 et la commande des pixels de détection du dispositif 300 sont par exemple synchronisées.

La figure 4 est une vue en coupe illustrant de façon schématique et partielle un autre exemple d'un dispositif optoélectronique selon un mode de réalisation.

Dans cet exemple, le dispositif optoélectronique intègre une source lumineuse distribuée émettant dans la gamme de sensibilité des photodiodes 171, par exemple une source infrarouge. Ceci permet de se passer de la source déportée 310 du système de la figure 3.

Le dispositif de la figure 4 comprend des éléments communs avec le dispositif de la figure 1J. Ces éléments ne seront pas détaillés à nouveau ci-après, et seules les différences par rapport au dispositif de la figure 1J seront mises en exergue.

Dans l'exemple de la figure 4, on a représenté deux LED 161(a) et 161(b) du dispositif, par exemple identiques ou similaires. Les LED 161(a) et 161(b) sont adaptées à émettre de la lumière dans la même gamme de longueurs d'ondes, par exemple de la lumière majoritairement bleue. Les modes de réalisation décrits ne se limitent toutefois pas à cet exemple particulier et la personne du métier saura adapter l'exemple de réalisation décrit en relation avec la figure 4 à d'autres couleurs d'émission des LED 161.

Dans cet exemple, la LED 161(a) est revêtue, du côté de sa face supérieure, par un élément de conversion photoluminescent 181(a) adapté à convertir la lumière émise par la LED en lumière visible à une autre longueur d'onde, par exemple en lumière rouge ou verte dans le cas d'une LED émettant de la lumière bleue.

A titre d'exemple, dans le cas de LED émettant de la lumière bleue, on pourra prévoir trois types de pixels d'émission de lumière visible adaptés à émettre respectivement de la lumière rouge (au moyen d'un élément de conversion photoluminescent convertissant la lumière bleue émise par la LED sous-jacente en lumière rouge), de la lumière verte (au moyen d'un élément de conversion photoluminescent convertissant la lumière bleue émise par la LED sous-jacente en lumière verte), et de la lumière bleue (sans élément de conversion).

La LED 161(b) est quant à elle revêtue, du côté de sa face supérieure, par un élément de conversion photoluminescent 181(b) adapté à convertir la lumière émise par la LED en un rayonnement lumineux dans la gamme de longueurs d'ondes détectée par les diodes photosensibles 171 du dispositif, par exemple un rayonnement infrarouge.

Ainsi, la LED 161(b) définit un pixel émissif PIR d'une source lumineuse intégrée au dispositif optoélectronique, adaptée à coopérer avec les diodes photosensibles 171 et remplaçant la source 310 du système de la figure 3.

Comme décrit précédemment, le dispositif de la figure 4 peut être un dispositif de type micro-écran monolithique, ou un pixel d'un dispositif de plus grandes dimensions.

Le nombre et le pas de répétition des pixels PIR pourra être choisi en fonction des besoins de l'application. Par exemple, le dispositif peut comprendre moins de pixels PIR que de pixels visibles (définis par les LED 161(a)) d'une même couleur d'émission. De préférence, le dispositif final (micro-écran monolithique ou dispositif étendu) comprend plusieurs pixels PIR répartis sur la surface du dispositif.

Les éléments de conversion 181(a), 181(b) surmontant les LED 161(a), 161(b) sont par exemple réalisés à base de boîtes quantiques ou à base de matériaux pérovskites, de préférence des matériaux pérovskites inorganiques, de préférence des matériaux pérovskites inorganiques épitaxiés. Les éléments de conversion à base de matériaux pérovskites sont par exemple déposés par dépôt laser pulsé (PLD).

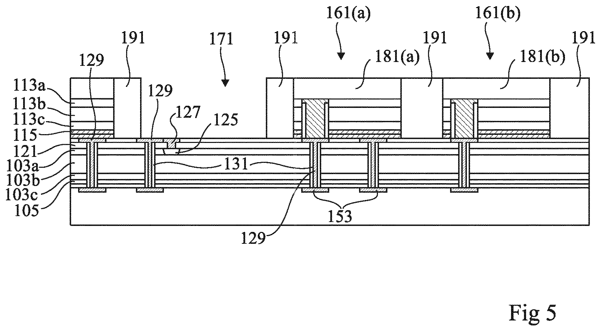

La figure 5 est une vue en coupe illustrant de façon schématique et partielle une variante de réalisation du dispositif de la figure 4.

La variante de la figure 5 diffère de l'exemple de la figure 4 en ce qu'elle comprend en outre des murs opaques 191, par exemple en résine, séparant latéralement les pixels émissifs les uns des autres et séparant latéralement les pixels émissifs des pixels de détection. Ceci permet notamment d'éviter que de la lumière émise par les pixels PIR n'atteigne directement les diodes photosensibles 171, sans passer par la scène dont on souhaite acquérir une image.

L'étendue de la présente invention est définie par les revendications qui suivent.

## Revendications

1. Procédé de fabrication d'un dispositif optoélectronique, comportant les étapes suivantes :
a) disposer un empilement actif de diode photosensible (103) sur un premier substrat (101) ;
b) reporter l'empilement actif de diode photosensible (103) sur un circuit intégré de contrôle (151) préalablement formé dans et sur un deuxième substrat semiconducteur, puis retirer le premier substrat (101) ;
c) disposer un empilement actif de diode électroluminescente (113) sur un troisième substrat (111) ; et
d) après les étapes b) et c), reporter l'empilement actif de diode électroluminescente (113) sur l'empilement actif de diode photosensible (103), puis retirer le troisième substrat (111).

2. Procédé selon la revendication 1, dans lequel l'empilement actif de diode photosensible (103) comprend au moins une couche semiconductrice inorganique, par exemple en un matériau III-V, et dans lequel l'empilement actif de diode électroluminescente (113) comprend au moins une couche semiconductrice inorganique, par exemple en un matériau III-V.

3. Procédé selon la revendication 1 ou 2, dans lequel l'empilement actif de diode photosensible (103) comprend des première (103a), deuxième (103b) et troisième (103c) couches semiconductrices, la deuxième couche (103b) étant disposée entre les première (103a) et troisième (103c) couches.

4. Procédé selon la revendication 3, comprenant une étape de dopage de type P de portions localisées (125) de la première couche (103a), lesdites portions définissant des régions d'anode de diodes photosensibles (171) du dispositif.

5. Procédé selon la revendication 4, dans lequel ladite étape de dopage de type P des portions localisées (125) de la première couche (103a) est mise en oeuvre après l'étape b) et avant l'étape d).

6. Procédé selon la revendication 4, dans lequel ladite étape de dopage de type P des portions localisées (125) de la première couche (103a) est mise en oeuvre avant l'étape b).

7. Procédé selon l'une quelconque des revendications 4 à 6, comprenant en outre une étape de formation de métallisations de connexion (127) sur et en contact avec lesdites portions localisées (125) de la première couche (103a).

8. Procédé selon l'une quelconque des revendications 1 à 7, dans lequel, à l'issue de l'étape b), l'empilement actif de diode photosensible (103) s'étend de façon continue sur toute la surface du circuit intégré de contrôle (151).

9. Procédé selon l'une quelconque des revendications 1 à 8, dans lequel, à l'issue de l'étape d), l'empilement actif de diode électroluminescente (113) s'étend de façon continue sur toute la surface du circuit intégré de contrôle (151).

10. Procédé selon l'une quelconque des revendications 1 à 9, comprenant en outre, après l'étape b) et avant l'étape d), une étape de formation de vias conducteurs (129) traversant l'empilement actif de diode photosensible (103).

11. Procédé selon la revendication 10, dans lequel les vias conducteurs (129) sont connectés électriquement à des plots métalliques de connexion (153) du circuit intégré (151) .

12. Procédé selon l'une quelconque des revendications 1 à 11, comprenant en outre, après l'étape d), une étape de gravure localisée de l'empilement actif de diode électroluminescente (113) de façon à former dans l'empilement actif de diode électroluminescente une pluralité de pavés (161) définissant chacun une diode électroluminescente.

13. Procédé selon la revendication 12, comprenant la formation d'éléments de conversion de couleur (181(a), 181(b)) au-dessus d'au moins certaines des diodes électroluminescentes (161(a), 161(b)).

14. Procédé selon la revendication 13, dans lequel au moins une (161(a)) desdites diodes électroluminescentes est surmontée d'un élément de conversion photoluminescent (181(a)) adapté à convertir la lumière émise par la diode électroluminescente vers une longueur d'onde visible et au moins une autre (161(b)) desdites diodes électroluminescentes est surmontée d'un élément de conversion photoluminescent (181(b)) adapté à convertir la lumière émise par la diode électroluminescente en un rayonnement lumineux dans la gamme de longueurs d'ondes de sensibilité de l'empilement actif de diode photosensible, de préférence un rayonnement infrarouge.

15. Procédé selon la revendication 14, dans lequel au moins une (161) desdites diodes électroluminescentes n'est pas surmontée par un élément de conversion photoluminescent.

16. Procédé selon l'une quelconque des revendications 13 à 15, dans lequel lesdits éléments de conversion photoluminescents (181(a), 181(b)) sont réalisés à base de boîtes quantiques ou de matériaux pérovskites.

17. Procédé selon l'une quelconque des revendications 1 à 12, comportant, après l'étape d), une étape de fixation d'un substrat de support temporaire (210) du côté de l'empilement actif de diode électroluminescente (113) opposé au circuit intégré (151), suivie d'une étape de découpe de l'ensemble comportant le circuit intégré (151), l'empilement actif de diode photosensible (103) et l'empilement actif de diode électroluminescente (113) en une pluralité de puces élémentaires (232).

18. Procédé selon la revendication 13, comportant en outre une étape de transfert et de fixation desdites puces élémentaires (232) sur un substrat de report (250) du dispositif, puis une étape de retrait du substrat de support temporaire (210).

19. Dispositif optoélectronique comportant un substrat de report (250) et une pluralité de puces élémentaires (232) fixées et connectées électriquement au substrat de report (250), chaque puce élémentaire (232) comportant un empilement comportant, dans l'ordre à partir de la face supérieure du substrat de report (250), un circuit intégré de contrôle (151) formé dans et sur un substrat semiconducteur, un étage de photodétection (201) comportant au moins une diode photosensible (171), et un étage d'émission (203) comportant au moins une diode électroluminescente (161).

20. Dispositif selon la revendication 19, dans lequel, dans chaque puce élémentaire, l'étage de photodétection (201) est disposé entre le circuit intégré de contrôle (151) et l'étage d'émission (203), et dans lequel ladite au moins une diode photosensible (171) a une couche semiconductrice d'anode (103a) disposée du côté de l'étage d'émission (203) et une couche semiconductrice de cathode (103c) disposée du côté du circuit intégré de contrôle (151).

21. Système comportant un dispositif optoélectronique (300) réalisé par un procédé selon l'une quelconque des revendications 1 à 18, le dispositif optoélectronique (300) comprenant un empilement actif de diode photosensible (103) reporté sur un circuit intégré de contrôle (151) formé dans et sur un substrat semiconducteur, et un empilement actif de diode électroluminescente (113) reporté sur l'empilement actif de diode photosensible (103), le système comportant une source lumineuse adaptée à émettre un rayonnement lumineux dans la gamme de longueurs d'ondes de sensibilité de l'empilement actif de diode photosensible (103), de préférence un rayonnement infrarouge.

22. Système selon la revendication 21, dans lequel la source lumineuse est une source déportée (310).

23. Système selon la revendication 21, dans lequel la source lumineuse est intégrée au dispositif optoélectronique (300) et comprend au moins une diode électroluminescente (161(b)) formée dans l'empilement actif de diode électroluminescente (113).

## Patentansprüche

1. Verfahren zum Herstellen einer optoelektronischen Einrichtung, das die folgenden Schritte aufweist:
a) Anordnen eines aktiven photosensitiven Diodenstapels (103) auf einem ersten Substrat (101);
b) Übertragen des aktiven photosensitiven Diodenstapels (103) auf eine integrierte Steuerschaltung (151), die zuvor innerhalb und auf einem zweiten Halbleitersubstrat ausgebildet wurde, und anschließendes Entfernen des ersten Substrats (101);
c) Anordnen eines aktiven Leuchtdiodenstapels (113) auf einem dritten Substrat (111); und
d) nach den Schritten b) und c) Übertragen des aktiven Leuchtdiodenstapels (113) auf den aktiven photosensitiven Diodenstapel (103) und anschließendes Entfernen des dritten Substrats (111).

2. Verfahren nach Anspruch 1, wobei der aktive photosensitive Diodenstapel (103) wenigstens eine anorganische Halbleiterschicht aufweist, die beispielsweise aus einem III-V-Material besteht, und wobei der aktive Leuchtdiodenstapel wenigstens eine anorganische Halbleiterschicht (113) aufweist, die beispielsweise aus einem III-V-Material besteht.

3. Verfahren nach Anspruch 1 oder 2, wobei der aktive photosensitive Diodenstapel (103) eine erste (103a), eine zweite (103b) und eine dritte (103c) Halbleiterschicht aufweist, wobei die zweite Schicht (103b) zwischen der ersten (103a) und der dritten (103c) Schicht angeordnet ist.

4. Verfahren nach Anspruch 3, aufweisend einen Schritt des P-Typ-Dotierens lokaler Abschnitte (125) der ersten Schicht (103a), wobei die Abschnitte Anodenbereiche von photosensitiven Dioden (171) der Einrichtung definieren.

5. Verfahren nach Anspruch 4, wobei der Schritt des P-Typ-Dotierens der lokalen Abschnitte (125) der ersten Schicht (103a) nach Schritt b) und vor Schritt d) durchgeführt wird.

6. Verfahren nach Anspruch 4, wobei der Schritt des P-Typ-Dotierens der lokalen Abschnitte (125) der ersten Schicht (103a) vor Schritt b) durchgeführt wird.

7. Verfahren nach einem der Ansprüche 4 bis 6, ferner aufweisend einen Schritt des Ausbildens von Verbindungsmetallisierungen (127) auf und in Kontakt mit den lokalen Abschnitten (125) der ersten Schicht (103a).

8. Verfahren nach einem der Ansprüche 1 bis 7, wobei sich am Ende von Schritt b) der aktive photosensitive Diodenstapel (103) kontinuierlich über die gesamte Oberfläche der integrierten Steuerschaltung (151) erstreckt.

9. Verfahren nach einem der Ansprüche 1 bis 8, wobei sich am Ende von Schritt d) der aktive Leuchtdiodenstapel (113) kontinuierlich über die gesamte Oberfläche der integrierten Steuerschaltung (151) erstreckt.

10. Verfahren nach einem der Ansprüche 1 bis 9, ferner aufweisend, nach Schritt b) und vor Schritt d), einen Schritt des Ausbildens von leitfähigen Vias (129), die den aktiven photosensitiven Diodenstapel (103) kreuzen.

11. Verfahren nach Anspruch 10, wobei die leitfähigen Vias (129) elektrisch mit Metallanschlusspads (153) der integrierten Schaltung (151) verbunden sind.

12. Verfahren nach einem der Ansprüche 1 bis 11, ferner aufweisend, nach Schritt d), einen Schritt des lokalen Ätzens des aktiven Leuchtdiodenstapels (113), um in dem aktiven Leuchtdiodenstapel eine Vielzahl von Kacheln (161) auszubilden, von denen jede eine Leuchtdiode definiert.

13. Verfahren nach Anspruch 12, aufweisend das Ausbilden von Farbkonversionselementen (181(a), 181(b)) über wenigstens einigen der Leuchtdioden (161(a), 161(b)).

14. Verfahren nach Anspruch 13, wobei wenigstens eine (161(a)) der Leuchtdioden mit einem photolumineszierenden Konversionselement (181(a)) versehen ist, das dazu ausgelegt ist, das von der Leuchtdiode emittierte Licht in eine sichtbare Wellenlänge zu konvertieren, und wenigstens eine weitere (161(b)) der Leuchtdioden mit einem photolumineszierenden Konversionselement (181(b)) versehen ist, das dazu ausgelegt ist, das von der Leuchtdiode emittierte Licht in eine Lichtstrahlung im Wellenlängenbereich der Empfindlichkeit des aktiven photosensitiven Diodenstapels, vorzugsweise eine Infrarotstrahlung, zu konvertieren.

15. Verfahren nach Anspruch 14, wobei wenigstens eine (161) der Leuchtdioden nicht mit einem photolumineszierenden Konversionselement versehen ist.

16. Verfahren nach einem der Ansprüche 13 bis 15, wobei die photolumineszierenden Konversionselemente (181(a), 181(b)) auf der Basis von Quantenpunkten oder Perowskitmaterialien ausgebildet sind.

17. Verfahren nach einem der Ansprüche 1 bis 12, aufweisend, nach Schritt d) einen Schritt des Verbindens eines temporären Trägersubstrats (210) auf der Seite des aktiven Leuchtdiodenstapels (113) gegenüber der integrierten Schaltung (151), gefolgt von einem Schritt des Schneidens aus der Anordnung, die die integrierte Schaltung (151) aufweist, des aktiven photosensitiven Diodenstapels (103) und des aktiven Leuchtdiodenstapels (113) in eine Vielzahl von Elementarchips (232).

18. Verfahren nach Anspruch 13, ferner aufweisend einen Schritt des Übertragens und Verbindens der Elementarchips (232) auf ein Transfersubstrat (250) der Einrichtung, gefolgt von einem Schritt des Entfernens des temporären Trägersubstrats (210).

19. Optoelektronische Einrichtung, aufweisend ein Transfersubstrat (250) und eine Vielzahl von Elementarchips (232), die auf das Transfersubstrat (250) verbondet und elektrisch mit diesem verbunden sind, wobei jeder Elementarchip (232) einen Stapel aufweist, der in der Reihenfolge von der Oberseite des Transfersubstrats (250) aus gesehen Folgendes aufweist: eine integrierte Steuerschaltung (151), die innerhalb und auf einem Halbleitersubstrat ausgebildet ist, eine Photodetektionsstufe (201), die wenigstens eine photosensitive Diode (171) aufweist, und eine Emissionsstufe (203), die wenigstens eine Leuchtdiode (161) aufweist.

20. Einrichtung nach Anspruch 19, wobei in jedem Elementarchip die Photodetektionsstufe (201) zwischen der integrierten Steuerschaltung (151) und der Emissionsstufe (203) angeordnet ist und wobei die wenigstens eine photosensitive Diode (171) eine Halbleiteranodenschicht (103a) hat, die auf der Seite der Emissionsstufe (203) angeordnet ist, und eine Halbleiterkathodenschicht (103c) hat, die auf der Seite der integrierten Steuerschaltung (151) angeordnet ist.

21. System, das eine optoelektronische Einrichtung (300) aufweist, die nach einem der Ansprüche 1 bis 18 realisiert ist, wobei die optoelektronische Einrichtung (300) einen aktiven photosensitiven Diodenstapel (103) aufweist, der auf eine integrierte Steuerschaltung (151) übertragen ist, die in und auf einem Halbleitersubstrat ausgebildet ist, und einen aktiven Leuchtdiodenstapel (113) aufweist, der auf den aktiven photosensitiven Diodenstapel (103) übertragen ist, wobei das System eine Lichtquelle aufweist, die dazu ausgelegt ist, eine Lichtstrahlung im Wellenlängenbereich der Empfindlichkeit des aktiven photosensitiven Diodenstapels (103) zu emittieren, vorzugsweise eine Infrarotstrahlung.

22. System nach Anspruch 21, wobei die Lichtquelle eine entfernte Quelle (310) ist.

23. System nach Anspruch 21, wobei die Lichtquelle in die optoelektronische Einrichtung (300) integriert ist und wenigstens eine Leuchtdiode (161(b)) aufweist, die in dem aktiven Leuchtdiodenstapel (113) ausgebildet ist.

## Claims

1. Optoelectronic device manufacturing method, comprising the steps of:
a) arranging an active photosensitive diode stack (103) on a first substrate (101);
b) transferring the active photosensitive diode stack (103) onto an integrated control circuit (151) previously formed inside and on top of a second semiconductor substrate, and then removing the first substrate (101);
c) arranging an active light-emitting diode stack (113) on a third substrate (111); and
d) after steps b) and c), transferring the active light-emitting diode stack (113) onto the active photosensitive diode stack (103), and then removing the third substrate (111).

2. Method according to claim 1, wherein the active photosensitive diode stack (103) comprises at least one inorganic semiconductor layer, for example, made of a III-V material, and wherein the active light-emitting diode stack comprises at least one inorganic semiconductor layer (113), for example, made of a III-V material.

3. Method according to claim 1 or 2, wherein the active photosensitive diode stack (103) comprises first (103a), second (103b), and third (103c) semiconductor layers, the second layer (103b) being arranged between the first (103a) and third (103c) layers.

4. Method according to claim 3, comprising a step of P-type doping of local portions (125) of the first layer (103a), said portions defining anode regions of photosensitive diodes (171) of the device.

5. Method according to claim 4, wherein said step of P-type doping of the local portions (125) of the first layer (103a) is implemented after step b) and before step d).

6. Method according to claim 4, wherein said step of P-type doping of the local portions (125) of the first layer (103a) is implemented before step b).

7. Method according to any of claims 4 to 6, further comprising a step of forming of connection metallizations (127) on top of and in contact with said local portions (125) of the first layer (103a).

8. Method according to any of claims 1 to 7, wherein, at the end of step b), the active photosensitive diode stack (103) continuously extends over the entire surface of the integrated control circuit (151).

9. Method according to any of claims 1 to 8, wherein, at the end of step d), the active light-emitting diode stack (113) continuously extends over the entire surface of the integrated control circuit (151).

10. Method according to any of claims 1 to 9, further comprising, after step b) and before step d), a step of forming of conductive vias (129) crossing the active photosensitive diode stack (103).

11. Method according to claim 10, wherein the conductive vias (129) are electrically connected to metal connection pads (153) of the integrated circuit (151).

12. Method according to any of claims 1 to 11, further comprising, after step d), a step of local etching of the active light-emitting diode stack (113) to form in the active light-emitting diode stack a plurality of tiles (161), each defining a light-emitting diode.

13. Method according to claim 12, comprising the forming of color conversion elements (181(a), 181(b)) above at least some of the light-emitting diodes (161(a), 161(b)).

14. Method according to claim 13, wherein at least one (161(a)) of said light-emitting diodes is topped with a photoluminescent conversion element (181(a)) adapted to converting the light emitted by the light-emitting diode into a visible wavelength and at least another one (161(b)) of said light-emitting diodes is topped with a photoluminescent conversion element (181(b)) adapted to converting the light emitted by the light-emitting diode into a light radiation in the wavelength range of sensitivity of the active photosensitive diode stack, preferably an infrared radiation.

15. Method according to claim 14, wherein at least one (161) of said light-emitting diodes is not topped with a photoluminescent conversion element.

16. Method according to any of claims 13 to 15, wherein said photoluminescent conversion elements (181(a), 181(b)) are formed based on quantum dots or on perovskite materials.

17. Method according to any of claims 1 to 12, comprising, after step d), a step of bonding of a temporary support substrate (210) on the side of the active light-emitting diode stack (113) opposite to the integrated circuit (151), followed by a step of cutting of the assembly comprising the integrated circuit (151), the active photosensitive diode stack (103), and the active light-emitting diode stack (113) into a plurality of elementary chips (232).

18. Method according to claim 13, further comprising a step of transfer and of bonding of said elementary chips (232) onto a transfer substrate (250) of the device, followed by a step of removal of the temporary support substrate (210) .

19. Optoelectronic device comprising a transfer substrate (250) and a plurality of elementary chips (232) bonded and electrically connected to the transfer substrate (250), each elementary chip (232) comprising a stack comprising, in the order from the upper surface of the transfer substrate (250), an integrated control circuit (151) formed inside and on top of a semiconductor substrate, a photodetection stage (201) comprising at least one photosensitive diode (171), and an emission stage (203) comprising at least one light-emitting diode (161).

20. Device according to claim 19, wherein, in each elementary chip, the photodetection stage (201) is arranged between the integrated control circuit (151) and the emission stage (203), and wherein said at least one photosensitive diode (171) has a semiconductor anode layer (103a) arranged on the side of the emission stage (203) and a semiconductor cathode layer (103c) arranged on the side of the integrated control circuit (151).

21. System comprising an optoelectronic device (300) realized by a method according to any of claims 1 to 18, the optoelectronic device (300) an active photosensitive diode stack (103) transferred on an integrated control circuit (151) formed in and on a semiconductor substrate, and an active an active light-emitting diode stack (113) transferred on the active photosensitive diode stack (103), the system comprising a light source adapted to emitting a light radiation in the wavelength range of sensitivity of the active photosensitive diode stack (103), preferably an infrared radiation.

22. System according to claim 21, wherein the light source is a remote source (310).

23. System according to claim 21, wherein the light source is integrated to the optoelectronic device (300) and comprises at least one light-emitting diode (161(b)) formed in the active light-emitting diode stack (113).
